# EUROPEAN PATENT SPECIFICATION

(11) **EP 3 666 937 B1**
(45) Date of publication and mention of the grant of the patent: **05.07.2023**
(21) Application number: 18922088.2
(22) Date of filing: 26.12.2018
(51) Int. Cl.: C30B 29/36, B24B 1/00, B24B 27/06, B24B 55/02, B24B 37/04, B24B 7/22, H01L 21/02

(54) **HIGH-FLATNESS, LOW-DAMAGE AND LARGE-DIAMETER MONOCRYSTALLINE SILICON CARBIDE SUBSTRATE, AND MANUFACTURING METHOD THEREFOR**
SEHR FLACHES MONOKRISTALLINES SILIZIUMKARBIDSUBSTRAT MIT GERINGER BESCHÄDIGUNG UND GROSSEM DURCHMESSER UND HERSTELLUNGSVERFAHREN DAFÜR
SUBSTRAT DE CARBURE DE SILICIUM MONOCRISTALLIN À PLANÉITÉ ÉLEVÉE, À FAIBLE ENDOMMAGEMENT ET DE GRAND DIAMÈTRE, ET SON PROCÉDÉ DE FABRICATION

(30) Priority: 16.10.2018 CN 201811205291; 16.10.2018 CN 201811205285
(43) Date of publication of application: 17.06.2020
(73) Proprietor: SICC CO., LTD., Jinan, Shandong 250118 (CN)
(72) Inventor: LIANG, Qingrui, Jinan, Shandong 250118 (CN); WANG, Hanguan, Jinan, Shandong 250118 (CN); WANG, Rui, Jinan, Shandong 250118 (CN); SHI, Wending, Jinan, Shandong 250118 (CN)
(74) Representative: Huang, Liwei
(86) International application number: PCT/CN2018/123718
(87) International publication number: WO 2020/077849

(56) References cited:
- WO-A1-2014/065949
- CN-A- 102 533 124
- CN-A- 103 935 990
- CN-A- 104 465 720
- CN-B- 103 722 625
- DE-T5-112015 004 795
- US-A- 6 046 112

## Description

### TECHNICAL FIELD

The present application relates to the field of crystal material processing technologies, and more particularly, to a high-flatness low-damage large-diameter single crystal silicon carbide substrate and a preparation method thereof.

### BACKGROUND

Single crystal silicon carbide is one of the most important third-generation semiconductor materials; and due to excellent properties such as wide band gap, high saturation electron mobility, strong breakdown field, and high thermal conductivity, it has broad application prospects in fields such as power electronics, radio frequency devices, and optoelectronic devices.

At present, commercial single crystal silicon carbide is usually grown by using a physical vapor transport (PVT)method, and then subjected to end face processing, multi-line cutting, grinding, mechanical polishing, chemical mechanical polishing, cleaning and packaging, to form an epi-ready silicon carbide substrate. With a Mohs of 9.2, second only to carbite in nature, single crystal silicon carbide is very hard to be processed physically; moreover, silicon carbide has high chemical stability, such as acid and alkali resistance and oxidation resistance, which greatly increases a difficulty in chemical mechanical polishing (CMP). Chemical mechanical polishing is currently the only global flattening polishing method, using a chemical polishing solution containing a strong oxidizing chemical agent and particles as an abrasive. During the polishing process, a chemical action and a mechanical action simultaneously act on a surface of the wafer to remove a damage layer on the surface of the wafer.

In view of the difficulty in processing the silicon carbide material, at present, a method of primary processing→sand line cutting→free abrasive grinding→copper disc polishing→tin disc polishing→coarse CMP→fine CMP is usually used, which has problems such as too cumbersome processing steps, low efficiency, difficulty in cleaning the free abrasive during processing, low first time yield, poor surface quality (TTVBow/Warp), and difficulty in eliminating subsurface damage. If damage exists in the surface of the substrate after the processing is completed, it will directly spread to a surface of an epitaxial wafer in a form of a triangular defect, forming a large amount of failed regions. In a next process of fabricating a chip, these failed regions will greatly reduce a chip yield, and serve as a primary factor affecting the chip yield.

In the prior art, sand line cutting is used, which is a cutting method similar to grinding, and has a very weak cutting force, so that processing efficiency is greatly reduced; in the free abrasive grinding process, large particles of the free abrasive will generate deep scratches, which is hard to be removed in a next process. Copper disc polishing and tin disc polishing belong to a one-sided processing method, and since a disc surface is relatively soft, wafer surface quality (TTV/LTV/BOW/Warp) will be seriously affected in a case of poor control of flatness of the disc surface.

Conventional alkaline CMP processing has always had contradiction between surface quality and removal rate: a high-hardness abrasive can improve the removal rate, but will cause surface damage; a low-hardness abrasive can result in a high-quality surface, but a very low removal rate. If there is a damage layer, the wafer surface finally obtained will have a fatal effect on application.

WO2014/065949 A1 forms the closest prior art for the subject-matter of claim 1 and CN103 722 625 B forms the closest prior art for the method steps cited in claim 7.

### SUMMARY

In view of the defects existing in the prior art, an objective of the present application is to provide a high-flatness low-damage large-diameter single crystal silicon carbide substrate and a preparation method thereof, wherein, the substrate has surface roughness ≤ 0.2 nm, and no subsurface damage layer. The single crystal silicon carbide substrate prepared by using the preparation method according to the present application has surface roughness, a fine scratch die (unqualified square) proportion, a pit proportion and a bump proportion which are all relatively low, and it also has good surface data, small thickness deviation, small Bow and small Warp.

In order to achieve the above objective, technical solutions used in the present application are:

In one aspect, the present application provides a high-flatness low-damage large-diameter single crystal silicon carbide substrate, the substrate having surface roughness ≤ 0.2 nm and no subsurface damage layer.

Further, the surface roughness is ≤ 0.10 nm, a fine scratch die proportion of the substrate is < 10%, a pit proportion is < 0.1 /cm², and a bump proportion is < 0.1 /cm².

Further, the surface roughness is ≤ 0.09 nm, the fine scratch die proportion is < 8%, the pit proportion is < 0.08 /cm², and the bump proportion is < 0.08 /cm²

Further, the surface roughness is ≤ 0.07 nm, the fine scratch die proportion is < 6%, the pit proportion is < 0.05 /cm², and the bump proportion is < 0.05 /cm².

Further, the surface roughness is ≤ 0.05 nm, the fine scratch die proportion is < 4%, the pit proportion is < 0.03 /cm², and the bump proportion is < 0.03 /cm².

Further, a thickness of the substrate is less than 500 um. Preferably, the thickness of the substrate is less than 350 um. More preferably, the thickness of the substrate is less than 200 um. More preferably, the thickness of the substrate is less than100 um. More preferably, the thickness of the substrate is less than 50 um.

Further, a diameter of the substrate is one of 100 mm (4 inches), 150 mm (6 inches) and 200 mm (8 inches). Preferably, the diameter of the substrate is one of 150 mm (6 inches) and 200 mm (8 inches).

Further, the diameter of the substrate is 100 mm (4 inches), and its surface data is: total thickness variation (TTV) < 5 um, local thickness variation (LTV) (1 cm^{∗}1 cm) < 2 um, Bow < 20 um, Warp < 40um.

Preferably, the surface data is: TTV < 3 um, LTV (1 cm * 1 cm) < 1.5 um, Bow < 15 um, Warp < 30 um. More preferably, the surface data is: TTV < 1 um, LTV (1cm * 1cm) < 1 um, Bow < 10 um, Warp < 20 um. More preferably, the surface data is: TTV < 0.5 um, LTV (1 cm^{∗}1 cm) < 0.5 um, Bow < 5 um, Warp < 10 um. More preferably, the surface data is: TTV < 0.1 um, LTV (1 cm * 1 cm) < 0.08 um, Bow < 2 um, Warp < 5 um. More preferably, the surface data is: TTV < 0.08 um, LTV (1 cm * 1 cm) < 0.08 um, Bow < 0.5 um, Warp < 1 um.

Further, the diameter of the substrate is 150 mm (6 inches), and its surface data is: TTV < 10 um, LTV (1 cm*1 cm) < 2 um, Bow < 40 um, Warp < 60 um. Preferably, the surface data is: TTV < 5 um, LTV (1 cm*1 cm) < 1.5 um, Bow < 30 um, Warp < 50 um. More preferably, the surface data is: TTV < 3 um, LTV (1 cm*1 cm) < 1 um, Bow < 20 um, Warp < 30 um. More preferably, the surface data is: TTV < 1 um, LTV (1 cm^{∗}1 cm) < 0.5 um, Bow < 10 um, Warp < 15 um. More preferably, the surface data is: TTV < 0.15 um, LTV (1 cm^{∗}1 cm) < 0.12 um, Bow < 3 um, Warp < 8 um. More preferably, the surface data is: TTV < 0.1 um, LTV (1 cm^{∗}1 cm) < 0.1 um, Bow < 1 um, Warp < 2 um.

Further, the diameter of the substrate is 200 mm (8 inches), and its surface data is: TTV < 10 um, LTV (1 cm*1 cm) < 2 um, Bow < 50 um, Warp < 70 um. Preferably, the surface data is: TTV < 6 um, LTV (1 cm*1 cm) < 1.5 um, Bow < 40 um, Warp < 60 um. More preferably, the surface data is: TTV < 4 um, LTV (1 cm*1 cm) < 1 um, Bow < 30 um, Warp < 50 um. More preferably, the surface data is: TTV < 2 um, LTV (1 cm^{∗}1 cm) < 0.5 um, Bow < 20 um, Warp < 40 um. More preferably, the surface data is: TTV < 1 um, LTV (1 cm^{∗}1 cm) < 0.5 um, Bow < 5 um, Warp < 10 um; and more preferably, the surface data is: TTV < 0.5 um, LTV (1 cm^{∗}1 cm) < 0.2um, Bow < 3um, Warp < 5um.

Optionally, a preparation method of the high-flatness low-damage large-diameter single crystal silicon carbide substrate comprises steps of:

Performing fully-consolidified abrasive processing on single crystal silicon carbide, and then performing a chemical mechanical polishing treatment, to obtain the high-flatness low-damage single crystal silicon carbide substrate;

Wherein, the consolidated abrasive processing includes line cutting and sand wheel grinding, the line has abrasive particles consolidated thereon, and the sand wheel has abrasive particles consolidated thereon.

Optionally, the line cutting is specifically diamond line cutting, wherein, abrasive particles having a mass percentage concentration of 2% to 10% are added into a cooling liquid used in the diamond line cutting process;

The sand wheel grinding includes two steps of coarse grinding and fine grinding, wherein, the coarse grinding has abrasive particles of about 13 to 2.6 µm (1,000 to 5,000 meshes) consolidated on the grinding sand wheel, and the fine grinding has abrasive particles of about 0.65 to 0.43 µm (20,000 to 30,000 meshes) consolidated on the grinding sand wheel.

Optionally, the chemical mechanical polishing is acid chemical mechanical polishing, wherein, a polishing liquid used in the acid chemical mechanical polishing step includes: an abrasive, an oxidant, a water-soluble acid polymer and RO water.

In another aspect, the present application further provides a preparation method of a high-flatness low-damage large-diameter single crystal silicon carbide substrate, and the preparation method of the substrate comprises steps of: performing fully-consolidified abrasive processing on single crystal silicon carbide, and then performing a chemical mechanical polishing treatment to obtain the high-flatness low-damage single crystal silicon carbide substrate; wherein, the consolidated abrasive processing includes line cutting and sand wheel grinding, the cutting line has abrasive particles consolidated thereon, and the sand wheel has abrasive particles consolidated thereon.

Further, the abrasive particles are selected from one or more of silicon oxide, aluminum oxide, cerium oxide, silicon carbide, boron carbide, zirconium oxide and carbite.

Further, before the single crystal silicon carbide is subjected to diamond line cutting, the single crystal silicon carbide is further subjected to initial processing, wherein, the initial processing is performed in a consolidated abrasive processing mode.

Further, the line cutting is specifically diamond line cutting.

Further, abrasive particles are added to a cooling liquid used in the diamond line cutting process, wherein, a mass percentage concentration of the abrasive particles in the cooling liquid is 2% to 10%. The abrasive particle may be one or more of aluminum oxide, carbite and boron carbide. The abrasive particle has a particle size of 50 nm to 100 nm. Preferably, the abrasive particle has a particle size from 60 nm to 80 nm.

Further, in the diamond line cutting processing step, cutting line tension is 22 N to 40 N, a line running speed is 1,200 m/min to 1,800 m/min, a rocking angle is 1° to 10°, a feed speed is 5 mm/h to 15 mm/h, and a diamond line diameter is 0.12 mm to 0.28 mm. Preferably, in the diamond line cutting processing step, the cutting line tension is 30 N to 40 N, the line running speed is 1,300 m/min to 1,600 m/min, the rocking angle is 3° to 8°, the feed speed is 8 mm/h to 12 mm/h, and the diamond line diameter is 0.15 mm to 0.20 mm. More preferably, in the diamond line cutting processing step, the cutting line tension is 33 N to 38 N, the line running speed is 1,400 m/min to 1,500 m/min, the rocking angle is 4° to 6°, the feed speed is 9 mm/h to 11 mm/h, and the diamond line diameter is 0.15 mm to 0.18mm.

A principle of the diamond line cutting method is that: a mesh of equal-spaced diamond lines is formed between sheaves (through metal nickel), and a cutting effect is achieved through reciprocation of the line mesh at a high speed. The present application has lower roughness of a cutting surface and a lower knife mark rate, by adding abrasive particles of a certain concentration in the cooling liquid, wherein, the particles may be aluminum oxide, carbite and boron carbide, etc., and have a mass percentage concentration of 2% to 10%, and by combining a conventional mortar cutting method and consolidated mortar line cutting method.

Further, the sand wheel grinding includes two steps of coarse grinding and fine grinding. Wherein, the coarse grinding has abrasive particles of about 13 to 2.6 µm (1,000 to 5,000 meshes) consolidated on the grinding sand wheel; and the fine grinding has abrasive particles of about 0.65 to 0.43 µm (20,000 to 30,000 meshes) consolidated on the grinding sand wheel. Preferably, the coarse grinding has abrasive particles of about 6.5 to 3.4 µm (2,000 to 4,000 meshes) consolidated on the grinding sand wheel; and the fine grinding has abrasive particles of about 0.5 to 0.43 µm (25,000 to 30,000 meshes) consolidated on the grinding sand wheel. More preferably, the coarse grinding has abrasive particles of about 5 µ m (3,000 meshes) consolidated on the grinding sand wheel; and the fine grinding has abrasive particles of about 0.46 µm (28,000 meshes) consolidated on the grinding sand wheel.

Further, in the coarse grinding step, the grinding sand wheel has a rotation speed of 1,000 rpm to 2,000 rpm, and a feed speed of 0.2 um/s to 1 um/s; and in the fine grinding step, the grinding sand wheel has a rotation speed of 1,000 rpm to 2,000 rpm, and a feed speed of 0.2 um/s to 1 um/s. Preferably, in the coarse grinding step, the grinding sand wheel has a rotation speed of 1,300 rpm to 1,600 rpm, and a feed speed of 0.6 um/s to 0.8 um/s; and in the fine grinding step, the grinding sand wheel has a rotation speed of 1,000 rpm to 1,200 rpm, and a feed speed of 0.4 um/s to 0.6 um/s.

A principle of the sand wheel grinding is that: single-sided processing is performed on the wafer with a resin sand wheel containing carbite particles. The wafer rotates at a low speed, the sand wheel rotates at a high speed, and sand wheels of different meshes will result in different degrees of processed surface roughness.

Further, the chemical mechanical polishing is specifically acid chemical mechanical polishing.

Further, the polishing liquid used in the acid chemical mechanical polishing treatment step includes: an abrasive, an oxidant, a water-soluble acid polymer and RO water; wherein, the abrasive has a mass percentage concentration of 1% to 30%; the abrasive is selected from one or more of silicon oxide, aluminum oxide, diamond particles, cerium oxide, silicon carbide, boron carbide, zirconium oxide and carbite; the oxidant is selected from one or more of hydrogen peroxide, potassium permanganate, nitric acid, hydrochloric acid and potassium perchlorate; the water-soluble acid polymer is selected from one or more of a carboxyl polymer and a sulfonic acid polymer.

Further, the polishing liquid used in the acid chemical mechanical polishing treatment step includes: an abrasive, an oxidant, a water-soluble acid polymer, a dispersant and RO water; wherein, the abrasive has a mass percentage concentration of 1% to 30%; the abrasive is selected from one or more of silicon oxide, aluminum oxide, diamond particles, cerium oxide, silicon carbide, boron carbide, zirconium oxide and carbite; the oxidant is selected from one or more of hydrogen peroxide, potassium permanganate, nitric acid, hydrochloric acid and potassium perchlorate; the water-soluble acid polymer is selected from one or more of a carboxyl polymer and a sulfonic acid polymer; the dispersant is selected from one or more of higher alcohol, polyvinyl alcohol and polyethylene glycol; and the dispersant has a mass percentage concentration of 0.2% to 1%.

Adding the water-soluble acid polymer in the polishing liquid not only functions to control a pH value of the polishing liquid, but also functions to maintain dispersion stability of the polishing liquid. After the water-soluble acid polymer is added, the pH value of the polishing liquid remains within a range of 2 to 4 during the chemical mechanical polishing process, and dispersion uniformity of the abrasives in the polishing liquid is substantially unaffected, which reduces possibilities of scratches and damages on the polished surface of the product.

Further, the polishing liquid may further include components below: a corrosion inhibitor, a viscosity modifier, a surfactant, an antibacterial agent, and so on.

Further, in the acid chemical mechanical polishing treatment step, the acid chemical mechanical polishing liquid has a pH value of 2 to 4, a rotation speed of 20 rpm to 50 rpm, a pressure of 200 g/cm² to 500 g/cm², and a material flow rate of 3 L/min to 10 L/min. Preferably, in the acid chemical mechanical polishing treatment step, the acid chemical mechanical polishing liquid has a pH value of 2.5 to 3.5, a rotation speed of 25 rpm to 45 rpm, a pressure of 250 g/cm² to 450 g/cm², and a material flow rate of 5 L/min to 7 L/min. More preferably, in the acid chemical mechanical polishing treatment step, the acid chemical mechanical polishing liquid has a pH value of 3.0 to 3.5, a rotation speed of 30 rpm to 40 rpm, a pressure of 300 g/cm² to 400 g/cm², and a material flow rate of 6 L/min to 7 L/min.

The present application has advantageous effects below:
1. In the present application, the fully-consolidated abrasive processing method is used, which can greatly improve processing efficiency; the consolidated abrasive replaces conventional free abrasive grinding and polishing, and has an advantage that the abrasives are inlaid on a carrier, which generates very shallow inlay scratches, and solves a scratch problem caused by abrasive accumulation and abrasive disc inlay. By consolidated abrasive grinding, high points on the surface of the wafer can be effectively removed, the sand wheel is not easily deformed, the processed surface has good parameters, and thus, flatness of the wafer is improved.
2. In the present application, processing is performed with the sand wheel consolidated with abrasives, and the single crystal silicon carbide substrate obtained has better surface data, and has total thickness variation, local thickness variation, Bow and Warp which are relatively low.
3. In the present application, the acid CMP processing method is used, which can quickly and effectively remove damages caused by the grinding process, improve the efficiency by 5 to 10 times, and at a same time, ensure the surface roughness of the wafer to be ≤ 0.2 nm. The substrate prepared in the present application has no subsurface damage layer.
4. The processing method of the single crystal silicon carbide substrate according to the present application is applicable to processing of a substrate of about 50 mm, 75 mm, 100 mm, 150 mm or 200 mm (2, 3, 4, 6 or 8 inches); and the larger the substrate size, the more obvious the advantage.

### BRIEF DESCRIPTION OF THE DRAWINGS

The drawings illustrated here are provided for further understanding the embodiments of the present application and constitute a part of the present application, and are used for explaining the present application together with the exemplary embodiments of the present application and description thereof, rather than improperly limiting the present application. In the drawings:
FIG. 1 is an AFM surface topographical view of a single crystal silicon carbide substrate prepared by using a conventional processing method.
FIG. 2 is an AFM surface topographical view of a single crystal silicon carbide substrate prepared by using a method according to the present application.

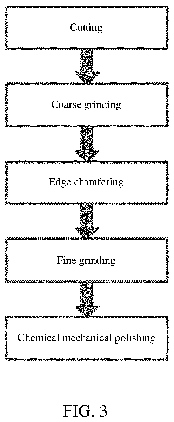

FIG. 3 is a flow chart of a preparation method of a high-flatness low-damage single crystal silicon carbide substrate according to the present application.

### DETAILED DESCRIPTION

In order to explain the overall concept of the present application more clearly, detailed description is provided below by way of examples in conjunction with the accompanying drawings.

A preparation method of a high-flatness low-damage single crystal silicon carbide substrate is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 22 N to 40 N, a line running speed is 1,200 m/min to 1,800 m/min, a rocking angle is 1° to 10°, a feed speed is 5 mm/h to 15 mm/h, and a diamond line diameter is 0.12 mm to 0.28 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 13 to 2.6 µm (1,000 meshes to 5,000 meshes), a rotation speed, and a feed speed; in the fine grinding, the sand wheel has approximately 0.65 to 0.43 µm (20,000 meshes to 30,000 meshes), a rotation speed of 1,000 rpm to 2,000 rpm and a feed speed of 0.2 um/s to 1 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 2 to 4, a rotation speed at 20 rpm to 50 rpm, a pressure at 200 g/cm² to 500 g/cm², and a material flow rate at 3 L/min to 10 L/min.

### Embodiment 1

A preparation method of a high-flatness low-damage single crystal silicon carbide substrate having a diameter of 100 mm is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 22 N, a line running speed is 1,200 m/min, a rocking angle is 5 °, a feed speed is 5 mm/h, and a diamond line diameter is 0.12 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 13 µm (1,000 meshes), a rotation speed, and a feed speed; in the fine grinding, the sand wheel has approximately 0.65 µm (20,000 meshes), a rotation speed of 1,000 rpm and a feed speed of 0.2 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 2, a rotation speed at 20 rpm, a pressure at 200 g/cm², and a material flow rate at 5 L/min.

The single crystal silicon carbide substrate having a diameter of 100 mm obtained in Embodiment 1 has technical parameters below:
Surface roughness is 0.05 nm, there is no subsurface damage layer, a fine scratch die proportion is 5%, a pit proportion is 0.05 /cm², and a bump proportion is 0.05 /cm².
Surface data: TTV is 2 um, LTV (1 cm*1 cm) is 1.5 um, Bow is 15 um, and Warp is 30 um.

### Embodiment 2

A preparation method of a high-flatness low-damage single crystal silicon carbide substrate having a diameter of 100 mm is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 40 N, a line running speed is 1,800 m/min, a rocking angle is 10°, a feed speed is 15 mm/h, and a diamond line diameter is 0.28 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 2.6 µm (5,000 meshes), a rotation speed, and a feed speed; in the fine grinding, the sand wheel has approximately 0.43 µm (30,000 meshes), a rotation speed of 2,000 rpm and a feed speed of 1 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 4, a rotation speed at 50 rpm, a pressure at 500 g/cm², and a material flow rate at 5 L/min.

The single crystal silicon carbide substrate having a diameter of 100 mm obtained in Embodiment 2 has technical parameters below:
Surface roughness is 0.08 nm, there is no subsurface damage layer, a fine scratch die proportion is 4%, a pit proportion is 0.03 /cm², and a bump proportion is 0.03 /cm².
Surface data: TTV is 1.5 um, LTV (1 cm*1 cm) is 1.1 um, Bow is 10 um, and Warp is 20 um.

### Embodiment 3

A preparation method of a high-flatness low-damage single crystal silicon carbide substrate having a diameter of 150 mm is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 30 N, a line running speed is 1,500 m/min, a rocking angle is 5 °, a feed speed is 10 mm/h, and a diamond line diameter is 0.15 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 5 µm (3,000 meshes), a rotation speed, and a feed speed; in the fine grinding, the sand wheel has approximately 0.5 µm (25,000 meshes), a rotation speed of 1,500 rpm and a feed speed of 0.5 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 3, a rotation speed at 30 rpm, a pressure at 300 g/cm², and a material flow rate at 8 L/min.

The single crystal silicon carbide substrate having a diameter of 150 mm obtained in Embodiment 3 has technical parameters below:
Surface roughness is 0.08 nm, there is no subsurface damage layer, a fine scratch die proportion is 6%, a pit proportion is 0.06 /cm², and a bump proportion is 0.05 /cm².
Surface data: TTV is 3 um, LTV (1 cm*1 cm) is 1.8 um, Bow is 17 um, and Warp is 25 um.

### Embodiment 4

A preparation method of a high-flatness low-damage single crystal silicon carbide substrate having a diameter of 150 mm is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 35 N, a line running speed is 1,600 m/min, a rocking angle is 5 °, a feed speed is 12 mm/h, and a diamond line diameter is 0.15 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 5 µm (3,000 meshes), a rotation speed, and a feed speed; in the fine grinding, the sand wheel has approximately 13 µm (25,000 meshes), a rotation speed of 1,500 rpm and a feed speed of 0.6 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 2.5, a rotation speed at 40 rpm, a pressure at 400 g/cm², and a material flow rate at 6 L/min.

The single crystal silicon carbide substrate having a diameter of 150 mm obtained in Embodiment 4 has technical parameters below:
Surface roughness is 0.01 nm, there is no subsurface damage layer, a fine scratch die proportion is 5%, a pit proportion is 0.03 /cm², and a bump proportion is 0.03 /cm².
Surface data: TTV is 1.4 um, LTV (1 cm^{∗}1 cm) is 0.9 um, Bow is 9 um, and Warp is 16 um.

### Embodiment 5

A preparation method of a high-flatness low-damage single crystal silicon carbide substrate having a diameter of 200 mm is provided, the preparation method comprising:
Step 1: initial processing: performing initial processing on the single crystal silicon carbide substrate;
Step 2: diamond line cutting: cutting, by a diamond line, single crystal silicon carbide subjected to initial processing in step 1, wherein, cutting line tension is 35 N, a line running speed is 1,500 m/min, a rocking angle is 4 °, a feed speed is 10 mm/h, and a diamond line diameter is 0.154 mm;
Step 3: sand wheel grinding: installing sand wheels of two types of meshes in two stations of a grinding apparatus, respectively for coarse grinding and fine grinding, and grinding the single crystal silicon carbide subjected to diamond line cutting in step 2, wherein, in the coarse grinding, the sand wheel has approximately 5 µm (3,000 meshes), a rotation speed, and a feed speed; in the fine grinding, the sand wheel has approximately 0.5 µm (25,000 meshes), a rotation speed of 1,500 rpm and a feed speed of 0.6 um/s;
Step 4: acid CMP processing: performing acid CMP processing with an acid chemical mechanical polishing liquid on the single crystal silicon carbide subjected to sand wheel grinding in step 3, and during the acid CMP processing, holding a pH value at 2, a rotation speed at 35 rpm, a pressure at 400 g/cm², and a material flow rate at 8 L/min.

The single crystal silicon carbide substrate having a diameter of 200 mm obtained in Embodiment 5 has technical parameters below:
Surface roughness is 0.01 nm, there is no subsurface damage layer, a fine scratch die proportion is 9%, a pit proportion is 0.03 /cm², and a bump proportion is 0.02 /cm².
Surface data: TTV is 3.5 um, LTV (1 cm*1 cm) is 2.3 um, Bow is 24 um, and Warp is 35 um.

### Comparative example 1

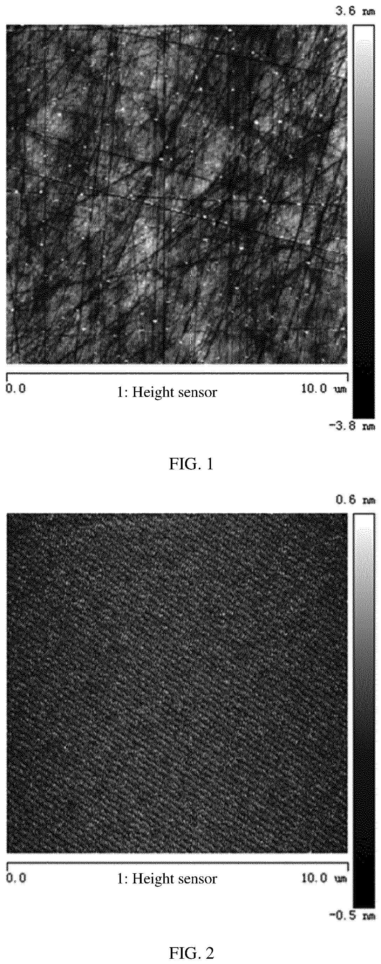

FIG. 1 shows an Atomic Force Microscope (AFM) surface topographical view of a 10 um * 10 um surface of a single crystal silicon carbide substrate prepared by using a conventional processing method; and from the AFM surface topographical view, the surface of the obtained substrate has more scratches and greater roughness, and the surface has a damage layer. FIG. 2 shows an AFM surface topographical view of a 10 um^{∗}10 um surface of a single crystal silicon carbide substrate prepared by using the method according to the present application; and from the AFM surface topographical view, the surface of the obtained substrate has almost no scratches, and has a better uniformity and low roughness, and the surface has no damage layer.

### Comparative example 2

Surface roughness and a knife mark rate of cut pieces obtained by adding and not adding abrasives to a cooling liquid in the diamond line cutting process are tested. Test results show that, in a case where no abrasives is added to the cooling liquid, the surface roughness of the cut piece is 500 nm to 700 nm, the knife mark rate is 5% to 10%; and after abrasives are added to the cooling liquid, the surface roughness of the cut piece is 200 nm to 400 nm, and the knife mark rate is < 5%.

A cutting rate of diamond line cutting is 5 to 10 times higher than a cutting rate of sand line cutting.

The contents not described in detail in the present specification belong to the prior art well known to those skilled in the art. The above are only embodiments of the present application, but are not intended to limit the present application.

## Claims

1. A high-flatness low-damage large-diameter single crystal silicon carbide substrate, wherein, the substrate has surface roughness ≤ 0.1 nm, and no subsurface damage layer; a thickness of the substrate is less than 350 µ m;
wherein the diameter of the substrate is 150 mm, and its surface data is: TTV < 3 um, LTV < 1 um, Bow < 20 um, Warp < 30 um, the LTV is 1cm * 1cm; or
the diameter of the substrate is 200 mm, and its surface data is: TTV < 10 um, LTV < 2 um, Bow < 50 um, Warp < 70 um, the LTV is 1cm * 1cm.

2. The high-flatness low-damage large-diameter single crystal silicon carbide substrate according to claim 1, wherein,
a fine scratch die proportion of the substrate is < 10%, a pit proportion is < 0.1 /cm², and a bump proportion is < 0.1 /cm².

3. The high-flatness low-damage large-diameter single crystal silicon carbide substrate according to claim 2, wherein,
the surface roughness of the substrate is ≤ 0.09 nm, the fine scratch die proportion of the substrate is < 8%, the pit proportion is < 0.08 /cm², and the bump proportion is < 0.08 /cm²;
in particular, the surface roughness of the substrate is ≤ 0.07 nm, the fine scratch die proportion of the substrate is < 6%, the pit proportion is < 0.05 /cm², and the bump proportion is < 0.05 /cm².

4. The high-flatness low-damage large-diameter single crystal silicon carbide substrate according to claim 1, wherein,
a thickness of the substrate is less than 50 um.

5. The high-flatness low-damage large-diameter single crystal silicon carbide substrate according to claim 1, wherein,
the diameter of the substrate is 150 mm, and its surface data is: TTV < 1 um, LTV < 0.5 um, Bow < 10 um, Warp < 15 um, the LTV is 1cm * 1cm.

6. The high-flatness low-damage large-diameter single crystal silicon carbide substrate according to claim 1, wherein,
the diameter of the substrate is 200 mm, and its surface data is: TTV < 4 um, LTV < 1 um, Bow < 30 um, Warp < 50 um, the LTV is 1cm * 1cm; and
in particular, the surface data is: TTV < 2 um, LTV < 0.5 um, Bow < 20 um, Warp < 40 um, the LTV is 1cm * 1cm.

7. A method of preparing a high-flatness low-damage large-diameter single crystal silicon carbide substrate according to any one of claims 1 to 6, wherein , the preparation method of the substrate comprises steps of:
performing fully-consolidified abrasive processing on single crystal silicon carbide, and then performing a chemical mechanical polishing treatment, to obtain the high-flatness low-damage single crystal silicon carbide substrate;
wherein, the consolidated abrasive processing includes line cutting and sand wheel grinding, the line has abrasive particles consolidated thereon, and the sand wheel has abrasive particles consolidated thereon;
the line cutting is specifically diamond line cutting, in the diamond line cutting processing step, cutting line tension is 22 N to 40 N, a line running speed is 1,200 m/min to 1,800 m/min, a rocking angle is 1 ° to 10 °, a feed speed is 5 mm/h to 15 mm/h, and a diamond line diameter is 0.12 mm to 0.28 mm.

8. The method of preparing the high-flatness low-damage large-diameter single crystal silicon carbide substrate according to claim 7, wherein,
abrasive particles having a mass percentage concentration of 2% to 10% are added into a cooling liquid used in the diamond line cutting process;
the sand wheel grinding includes two steps of coarse grinding and fine grinding, wherein, the coarse grinding has abrasive particles of about 13 to 2.6 µ m (1,000 to 5,000 meshes) consolidated on the grinding sand wheel, and the fine grinding has abrasive particles of about 0.65 to 0.43 µ m (20,000 to 30,000 meshes) consolidated on the grinding sand wheel.

9. The method of preparing the high-flatness low-damage large-diameter single crystal silicon carbide substrate according to claim 7, wherein,
the chemical mechanical polishing is acid chemical mechanical polishing, wherein, a polishing liquid used in the acid chemical mechanical polishing step includes: an abrasive, an oxidant, a water-soluble acid polymer and RO water.

10. The method of preparing the high-flatness low-damage large-diameter single crystal silicon carbide substrate according to claim 8, wherein,
the abrasive particle used in the cooling liquid is selected from one or more of aluminum oxide, carbite and boron carbide; and the abrasive particle has a particle size of 50 nm to 100 nm;
in the diamond line cutting processing step, the cutting line tension is 30 N to 40 N, the line running speed is 1,300 m/min to 1,600 m/min, the rocking angle is 3 ° to 8 °, the feed speed is 8 mm/h to 12 mm/h, and the diamond line diameter is 0.15 mm to 0.20 mm.

11. The method of preparing the high-flatness low-damage large-diameter single crystal silicon carbide substrate according to claim 8, wherein,
in the coarse grinding step, the grinding sand wheel has a rotation speed of 1,000 rpm to 2,000 rpm, and a feed speed of 0.2 um/s to 1 um/s; and in the fine grinding step, the grinding sand wheel has a rotation speed of 1,000 rpm to 2,000 rpm, and a feed speed of 0.2 um/s to 1 um/s.

12. The method of preparing the high-flatness low-damage large-diameter single crystal silicon carbide substrate according to claim 7, wherein,
the chemical mechanical polishing is acid chemical mechanical polishing,
the polishing liquid used in the acid chemical mechanical polishing treatment step includes: an abrasive, an oxidant, a water-soluble acid polymer, a dispersant and RO water;
wherein, the abrasive has a mass percentage concentration of 1% to 30%;
the abrasive is selected from one or more of silicon oxide, aluminum oxide, diamond particles, cerium oxide, silicon carbide, boron carbide, zirconium oxide and carbite;
the oxidant is selected from one or more of hydrogen peroxide, potassium permanganate, nitric acid, hydrochloric acid and potassium perchlorate;
the water-soluble acid polymer is selected from one or more of a carboxyl polymer and a sulfonic acid polymer;
the dispersant is selected from one or more of higher alcohol, polyvinyl alcohol and polyethylene glycol; and the dispersant has a mass percentage concentration of 0.2% to 1%.

13. The method of preparing the high-flatness low-damage large-diameter single crystal silicon carbide substrate according to claim 12, wherein,
in the acid chemical mechanical polishing treatment step, the acid chemical mechanical polishing liquid has a pH value of 2 to 4, a rotation speed of 20 rpm to 50 rpm, a pressure of 200 g/cm² to 500 g/cm², and a material flow rate of 3 L/min to 10 L/min.

## Patentansprüche

1. Hochflaches, beschädigungsarmes Einkristall-Siliciumcarbid-Substrat mit großem Durchmesser, wobei das Substrat eine Oberflächenrauigkeit von ≤ 0,1 nm und keine unter der Oberfläche liegende Beschädigungsschicht aufweist, eine Stärke des Substrats weniger als 350 µm ist;
wobei der Durchmesser des Substrats 150 mm ist und seine Oberflächendaten wie folgt sind: TTV < 3 um, LTV < 1 um, Verbiegung < 20 um, Verwölbung < 30 um, die LTV ist 1 cm * 1 cm; oder
der Durchmesser des Substrats ist 200 mm und die Oberflächendaten sind: TTV < 10 um, LTV < 2 um, Verbiegung < 50 um, Verwölbung < 70 um, die LTV ist 1cm * 1cm.

2. Hochflaches, beschädigungsarmes Einkristall-Siliciumcarbid-Substrat mit großem Durchmesser nach Anspruch 1, wobei
ein Anteil feiner Kratzer des Substrats ist < 10 %, ein Anteil von Vertiefungen ist < 0,1 /cm² und ein Anteil von Erhebungen ist < 0,1 /cm².

3. Hochflaches, beschädigungsarmes Einkristall-Siliciumcarbid-Substrat mit großem Durchmesser nach Anspruch 2, wobei
die Oberflächenrauigkeit des Substrats ≤ 0,09 nm ist, der Anteil feiner Kratzer des Substrats < 8 % ist, der Anteil von Vertiefungen < 0,08 /cm² ist und der Anteil von Erhebungen < 0,08 /cm² ist;
insbesondere die Oberflächenrauigkeit des Substrats ≤ 0,07 nm ist, der Anteil feiner Kratzer des Substrats < 6 % ist, der Anteil von Vertiefungen < 0,05 /cm² ist und der Anteil von Erhebungen < 0,05 /cm² ist.

4. Hochflaches, beschädigungsarmes Einkristall-Siliciumcarbid-Substrat mit großem Durchmesser nach Anspruch 1, wobei
eine Stärke des Substrats weniger als 50 um ist.

5. Hochflaches, beschädigungsarmes Einkristall-Siliciumcarbid-Substrat mit großem Durchmesser nach Anspruch 1, wobei
der Durchmesser des Substrats 150 mm ist, und seine Oberflächendaten wie folgt sind: TTV < 1 um, LTV < 0,5 um, Verbiegung < 10 um, Verwölbung < 15 um, die LTV ist 1cm * 1cm.

6. Hochflaches, beschädigungsarmes Einkristall-Siliciumcarbid-Substrat mit großem Durchmesser nach Anspruch 1, wobei
der Durchmesser des Substrats ist 200 mm und die Oberflächendaten wie folgt sind: TTV < 4 um, LTV < 1 um, Verbiegung < 30 um, Verwölbung < 50 um, die LTV ist 1 cm * 1 cm; und
insbesondere die Oberflächendaten wie folgt sind: TTV < 2 um, LTV < 0,5 um, Verbiegung < 20 um, Verwölbung < 40 um, die LTV ist 1cm * 1cm.

7. Verfahren zum Herstellen eines hochflachen, beschädigungsarmen Einkristall-Siliciumcarbid-Substrats mit großem Durchmesser nach einem der Ansprüche 1 bis 6, wobei das Herstellungsverfahren des Substrats folgende Schritte umfasst:
Ausführen einer vollkonsolidierten Schleifbearbeitung an Einkristall-Siliziumkarbid und anschließende chemisch-mechanische Polierbehandlung, um das hochflache, beschädigungsarme Einkristall-Siliciumcarbid-Substrat zu erlangen;
wobei die konsolidierte Schleifbearbeitung ein Schneiden von Linien und Schleifen mit Schleifscheibe beinhaltet, die Linie darauf konsolidierte Schleifpartikel aufweist und die Schleifscheibe darauf konsolidierte Schleifpartikel aufweist:
wobei das Schneiden von Linien speziell ein Schneiden von Diamantenlinien, in dem Diamantlinien-Schneidprozessschritt, eine Schneidlinienspannung 22 N bis 40 N ist, eine Linienlaufgeschwindigkeit 1200 m/Min. bis 1800 m/Min. ist, ein Kippwinkel 1 ° bis 10 ° ist, eine Vorschubgeschwindigkeit 5 mm/Std. bis 15 mm/Std. ist und ein Diamantliniendurchmesser 0,12 mm bis 0,28 mm ist.

8. Verfahren zum Herstellen eines hochflachen, beschädigungsarmen Einkristall-Siliciumcarbid-Substrats mit großem Durchmesser nach Anspruch 7, wobei
Schleifpartikel, die eine Massenprozentkonzentration von 2 % bis 10 % aufweisen, in eine Kühlflüssigkeit hinzugefügt werden, die bei dem Diamantlinien-Schneidprozess verwendet wird;
das Schleifen mit Schleifscheibe zwei Schritte des Grobschleifens und des Feinschleifens beinhaltet, wobei das Grobschleifen Schleifpartikel von etwa 13 bis 2,6 µm (1000 bis 5000 Mesh) aufweist, die auf der schleifenden Schleifscheibe konsolidiert sind, und das Feinschleifen Schleifpartikel von etwa 0,65 bis 0,43 µm (20.000 bis 30.000 Mesh) aufweist, die auf der schleifenden Schleifscheibe konsolidiert sind.

9. Verfahren zum Herstellen eines hochflachen, beschädigungsarmen Einkristall-Siliciumcarbid-Substrats mit großem Durchmesser nach Anspruch 7, wobei
das chemisch-mechanische Polieren ein säurechemisch-mechanisches Polieren ist, wobei eine Polierflüssigkeit, die in dem sauren chemisch-mechanischen Polierschritt verwendet wird, Folgendes beinhaltet: ein Schleifmittel, ein Oxidationsmittel, ein wasserlösliches Säurepolymer und RO-Wasser.

10. Verfahren zum Herstellen eines hochflachen, beschädigungsarmen Einkristall-Siliciumcarbid-Substrats mit großem Durchmesser nach Anspruch 8, wobei
das in der Kühlflüssigkeit verwendete Schleifpartikel ausgewählt ist aus einem oder mehreren von Aluminiumoxid, Karbit und Borkarbid; und das Schleifpartikel eine Partikelgröße von 50 nm bis 100 nm aufweist;
in dem Diamantlinien-Schneidprozessschritt die Schneidlinienspannung 30 N bis 40 N ist, die Linienlaufgeschwindigkeit 1300 m/Min bis 1600 m/Min ist, der Kippwinkel 3 ° bis 8 ° ist, die Vorschubgeschwindigkeit 8 mm/Std. bis 12 mm/Std. ist und der Diamantliniendurchmesser 0,15 mm bis 0,20 mm ist.

11. Verfahren zum Herstellen eines hochflachen, beschädigungsarmen Einkristall-Siliciumcarbid-Substrats mit großem Durchmesser nach Anspruch 8, wobei
in dem Grobschleifschritt die schleifende Schleifscheibe eine Drehgeschwindigkeit von 1000 U/min bis 2000 U/min und eine Vorschubgeschwindigkeit von 0,2 um/Sek. bis 1 um/Sek. aufweist; und in dem Feinschleifschritt die schleifende Schleifscheibe eine Drehgeschwindigkeit von 1000 U/min bis 2000 U/min und eine Vorschubgeschwindigkeit von 0,2 um/Sek. bis 1 um/Sek. aufweist.

12. Verfahren zum Herstellen eines hochflachen, beschädigungsarmen Einkristall-Siliciumcarbid-Substrats mit großem Durchmesser nach Anspruch 7, wobei
das chemisch-mechanische Polieren ein säurechemisches mechanisches Polieren ist,
die Polierflüssigkeit, die im Schritt der säurechemisch-mechanischen Polierbehandlung verwendet wird, Folgendes beinhaltet: ein Schleifmittel, ein Oxidationsmittel, ein wasserlösliches Säurepolymer, ein Dispersionsmittel und RO-Wasser;
wobei das Schleifmittel eine Massenprozentkonzentration von 1 % bis 30 % aufweist; das Schleifmittel ausgewählt ist aus einem oder mehreren von Siliziumoxid, Aluminiumoxid, Diamantpartikel, Ceroxid, Siliziumkarbid, Borkarbid, Zirkoniumoxid und Karbit;
das Oxidationsmittel ausgewählt ist aus einem oder mehreren von Wasserstoffperoxid, Kaliumpermanganat, Salpetersäure, Salzsäure und Kaliumperchlorat;
das wasserlösliche Säurepolymer ausgewählt ist aus einem oder mehreren von Carboxylpolymeren und Sulfonsäurepolymeren;
das Dispergiermittel ausgewählt ist aus einem oder mehreren von höherem Alkohol, Polyvinylalkohol und Polyethylenglykol; und das Dispergiermittel eine Massenprozentkonzentration von 0,2 % bis 1 % aufweist.

13. Verfahren zum Herstellen eines hochflachen, beschädigungsarmen Einkristall-Siliciumcarbid-Substrats mit großem Durchmesser nach Anspruch 12, wobei
in dem Behandlungsschritt des sauren chemisch-mechanischen Polierens die saure chemisch-mechanische Polierflüssigkeit einen pH-Wert von 2 bis 4, eine Drehgeschwindigkeit von 20 U/min bis 50 U/min, einen Druck von 200 g/cm² bis 500 g/cm² und eine Materialdurchflussrate von 3 1/Min bis 10 1/Min aufweist.

## Revendications

1. Substrat en carbure de silicium monocristallin, à grand diamètre, faible endommagement et planéité élevée, dans lequel le substrat a une rugosité de surface ≤ 0,1 nm, et aucune couche d'endommagement de sous-surface ; une épaisseur du substrat est inférieure à 350 µm ;
dans lequel le diamètre du substrat est de 150 mm, et ses données de surface sont : TTV (variation d'épaisseur totale) < 3 um, LTV(variation d'épaisseur locale) < 1 um, Bow (bombé) < 20 um, Warp (torsion) < 30 um, la LTV est de 1 cm * 1 cm ; ou
le diamètre du substrat est de 200 mm, et ses données de surface sont : TTV <10 um, LTV < 2 um, Bow < 50 um, Warp < 70 um, la LTV est de 1 cm * 1 cm.

2. Substrat en carbure de silicium monocristallin, à grand diamètre, faible endommagement et planéité élevée selon la revendication 1, dans lequel,
une proportion de fines rayures du substrat est < 10 %, une proportion de creux est < 0,1 /cm² et une proportion de bosses est < 0,1 /cm².

3. Substrat en carbure de silicium monocristallin, à grand diamètre, faible endommagement et planéité élevée selon la revendication 2, dans lequel,
la rugosité de surface du substrat est de ≤ 0,09 nm, la proportion de fines rayures du substrat est < 8 %, la proportion de creux est < 0,08 /cm² et la proportion de bosses est < 0,08 /cm² ;
en particulier, la rugosité de surface du substrat est de ≤ 0,07 nm, la proportion de fines rayures du substrat est < 6 %, la proportion de creux est < 0,05/cm² et la proportion de bosses est < 0,05/cm².

4. Substrat en carbure de silicium monocristallin, à grand diamètre, faible endommagement et planéité élevée selon la revendication 1, dans lequel,
une épaisseur du substrat est inférieure à 50 um.

5. Substrat en carbure de silicium monocristallin, à grand diamètre, faible endommagement et planéité élevée selon la revendication 1, dans lequel,
le diamètre du substrat est de 150 mm, et ses données de surface sont : TTV < 1 um, LTV < 0,5 um, Bow <10 um, Warp <15 um, la LTV est de 1 cm * 1 cm.

6. Substrat en carbure de silicium monocristallin, à grand diamètre, faible endommagement et planéité élevée selon la revendication 1, dans lequel,
le diamètre du substrat est de 200 mm, et ses données de surface sont : TTV < 4 um, LTV < 1 um, Bow < 30 um, Warp < 50 um, la LTV est de 1 cm * 1 cm ; et
en particulier, les données de surface sont : TTV < 2 um, LTV < 0,5 um, Bow < 20 um, Warp < 40 um, la LTV est de 1 cm * 1 cm.

7. Procédé de préparation d'un substrat en carbure de silicium monocristallin, à grand diamètre, faible endommagement et planéité élevée selon l'une quelconque des revendications 1 à 6, dans lequel le procédé de préparation du substrat comprend les étapes de :
exécution d'un traitement abrasif entièrement consolidé sur du carbure de silicium monocristallin, puis exécution d'un traitement de polissage mécano-chimique, pour obtenir le substrat de carbure de silicium monocristallin, à faible endommagement et planéité élevée ;
dans lequel, le traitement abrasif consolidé inclut une coupe de ligne et un meulage à roue de ponçage, la ligne a des particules abrasives consolidées sur celle-ci, et la roue de ponçage a des particules abrasives consolidées sur celle-ci ;
la coupe de ligne est spécifiquement une coupe de ligne de diamant, dans l'étape de traitement de coupe de ligne de diamant, la tension de ligne de coupe est de 22 N à 40 N, une vitesse de défilement de ligne est de 1 200 m/min à 1 800 m/min, un angle de basculement est de 1° à 10 °, une vitesse d'alimentation est de 5 mm/h à 15 mm/h, et un diamètre de ligne de diamant est de 0,12 mm à 0,28 mm.

8. Procédé de préparation d'un substrat en carbure de silicium monocristallin, à grand diamètre, faible endommagement et planéité élevée selon la revendication 7, dans lequel,
des particules abrasives ayant une concentration en pourcentage en masse de 2 % à 10 % sont ajoutées dans un liquide de refroidissement utilisé dans le processus de coupe de ligne de diamant ;
le meulage à roue de ponçage inclut deux étapes de ponçage grossier et de ponçage fin, dans lequel, le ponçage grossier a des particules abrasives d'environ 13 à 2,6 µm (1 000 à 5 000 mèches) consolidées sur la roue de ponçage, et le ponçage fin a des particules abrasives d'environ 0,65 à 0,43 µm (20 000 à 30 000 mèches) consolidés sur la roue de ponçage.

9. Procédé de préparation d'un substrat en carbure de silicium monocristallin, à grand diamètre, faible endommagement et planéité élevée selon la revendication 7, dans lequel,
le polissage mécanochimique est un polissage mécanochimique acide, dans lequel un liquide de polissage utilisé dans l'étape de polissage mécanochimique acide inclut : un abrasif, un oxydant, un polymère acide soluble dans l'eau et de l'eau RO.

10. Procédé de préparation du substrat en carbure de silicium monocristallin, à grand diamètre, faible endommagement et planéité élevée selon la revendication 8, dans lequel,
la particule abrasive utilisée dans le liquide de refroidissement est choisie parmi un ou plusieurs parmi l'oxyde d'aluminium, le carbure et le carbure de bore ; et la particule abrasive a une taille de particule de 50 nm à 100 nm ;
dans l'étape de traitement de coupe de ligne de diamant, la tension de ligne de coupe est de 30 N à 40 N, la vitesse de défilement de ligne est de 1 300 m/min à 1 600 m/min, l'angle de basculement est de 3° à 8°, la vitesse d'avance est de 8 mm /h à 12 mm/h, et le diamètre de ligne de diamant est de 0,15 mm à 0,20 mm.

11. Procédé de préparation du substrat en carbure de silicium monocristallin, à grand diamètre, faible endommagement et planéité élevée selon la revendication 8, dans lequel,
dans l'étape de ponçage grossier, la roue de ponçage a une vitesse de rotation de 1 000 tr/min à 2 000 tr/min et une vitesse d'avance de 0,2 um/s à 1 um/s ; et dans l'étape de ponçage fin, la roue de ponçage a une vitesse de rotation de 1 000 tr/min à 2 000 tr/min et une vitesse d'alimentation de 0,2 um/s à 1 um/s.

12. Procédé de préparation d'un substrat en carbure de silicium monocristallin, à grand diamètre, faible endommagement et planéité élevée selon la revendication 7, dans lequel,
le polissage mécano-chimique est un polissage mécano-chimique acide,
le liquide de polissage utilisé dans l'étape de traitement de polissage mécano-chimique acide comprend : un abrasif, un oxydant, un polymère acide soluble dans l'eau, un dispersant et de l'eau RO ;
dans lequel, l'abrasif a une concentration en pourcentage en masse de 1 % à 30 % ;
l'abrasif est choisi parmi un ou plusieurs parmi l'oxyde de silicium, l'oxyde d'aluminium, les particules de diamant, l'oxyde de cérium, le carbure de silicium, le carbure de bore, l'oxyde de zirconium et le carbure ;
l'oxydant est choisi parmi un ou plusieurs parmi le peroxyde d'hydrogène, le permanganate de potassium, l'acide nitrique, l'acide chlorhydrique et le perchlorate de potassium ;
le polymère d'acide soluble dans l'eau est choisi parmi un ou plusieurs parmi un polymère carboxyle et un polymère d'acide sulfonique ;
le dispersant est choisi parmi un ou plusieurs parmi un alcool supérieur, un alcool polyvinylique et un polyéthylène glycol ; et le dispersant a une concentration en pourcentage en masse de 0,2 % à 1 %.

13. Procédé de préparation du substrat en carbure de silicium monocristallin, à grand diamètre, faible endommagement et planéité élevée selon la revendication 12, dans lequel,
dans l'étape de traitement de polissage mécanochimique acide, le liquide de polissage mécanochimique acide a une valeur de pH de 2 à 4, une vitesse de rotation de 20 tr/min à 50 tr/min, une pression de 200 g/cm² à 500 g/cm², et un débit de matériau de 3 L/min à 10 L/min.
